# EUROPEAN PATENT APPLICATION

(11) **EP 2 450 964 A2**
(43) Date of publication of application: **09.05.2012**
(21) Application number: 10794347.4
(22) Date of filing: 30.06.2010
(51) Int. Cl.: H01L 31/042

(54) **PHOTOVOLTAIC POWER-GENERATING APPARATUS AND METHOD FOR MANUFACTURING SAME**

(30) Priority: 30.06.2009 KR 20090059502; 30.06.2009 KR 20090059513
(71) Applicant: LG Innotek Co., Ltd., Seoul 100-714 (KR)
(72) Inventor: CHO, Ho Gun, Seoul 100-714 (KR)
(74) Representative: Novagraaf Technologies
(86) International application number: PCT/KR2010/004226
(87) International publication number: WO 2011/002212

(57) **Abstract**

A solar cell apparatus and a method of fabricating the same are provided. The solar cell apparatus includes a substrate, a back electrode layer, a light absorption layer, and a front electrode layer. The back electrode layer is on the substrate. The light absorption layer is on the back electrode layer. The front electrode layer is on the light absorption layer. The back electrode layer is provided with recesses. Inner surfaces of the back electrode layer defining the recesses are inclined from a top surface of the substrate.

## Description

### TECHNICAL FIELD

Embodiments relate to a solar cell apparatus and a method of fabricating the solar cell apparatus.

### BACKGROUND ART

Recent increasing consumption of energy has facilitated development of solar cells capable of converting solar energy into electric energy.

Particularly, CuInGaSe (CIGS) solar cells are common, which are pn hetero junction devices having a substrate structure constituted by a glass substrate, a metal back electrode layer, a p-type CIGS light absorption layer, a high resistance buffer layer, and an n-type window layer.

In this case, the light absorption layer is patterned to connect electrodes to one another, and the buffer layer and the light absorption layer are patterned to form unit cells.

To this end, a vacuum state should be changed to an atmospheric state. In addition, each layer may be ripped off through a mechanical patterning process, or layers adjacent to a pattern may be burred through a laser patterning process, which degrade electrical characteristics of a solar cell.

### DISCLOSURE OF THE INVENTION

### TECHNICAL PROBLEM

Embodiments provide a solar cell apparatus and a method of fabricating the solar cell apparatus, which reduces process time and prevents deformation of each layer.

### TECHNICAL SOLUTION

In one embodiment, a solar cell apparatus includes: a substrate; a back electrode layer on the substrate; a light absorption layer on the back electrode layer; and a front electrode layer on the light absorption layer, wherein the back electrode layer is provided with recesses, and inner surfaces of the back electrode layer defining the recesses are inclined from a top surface of the substrate.

In another embodiment, a solar cell apparatus includes: a substrate; a back electrode layer on the substrate; a light absorption layer on the back electrode layer; and a front electrode layer on the light absorption layer, wherein the light absorption layer is provided with recesses, and inner surfaces of the light absorption layer defining the recesses are inclined from a top surface of the substrate.

In another embodiment, a method of fabricating a solar cell apparatus includes: forming a back electrode layer on a substrate; forming a light absorption layer on the back electrode layer; and forming a front electrode layer on the light absorption layer, wherein, in the forming of the back electrode layer, the light absorption layer, or the front electrode layer, a mask is disposed on the substrate, and then, a raw material used to form the back electrode layer, the light absorption layer, or the front electrode layer is deposited.

### ADVANTAGEOUS EFFECTS

According to the embodiment, the back electrode layer, the light absorption layer, and the front electrode layer are formed by performing deposition and patterning processes at the same time by means of the mask. Thus, an addition process such as laser patterning or mechanical scribing is unnecessary.

Thus, the back electrode layer, the light absorption layer, and the front electrode layer can be formed all in a vacuum, and the process time can be reduced.

In addition, when the back electrode layer, the light absorption layer, and the front electrode layer are formed, the mask is used in the patterning process, and thus, the back electrode layer, the light absorption layer, and the front electrode layer can be protected from a mechanical shock. That is, ripping of the back electrode layer, the light absorption layer, and the front electrode layer due to a process such as mechanical scribing can be prevented.

In addition, since the patterning process can be more precisely performed than a mechanical patterning process, the non-active area NAA can be decreased, thereby improving the efficiency of the solar cell apparatus.

In addition, since the inner surfaces of the light absorption layer defining the recesses are inclined, the material used to form the front electrode layer can be efficiently deposited on the inner surfaces, thereby forming contact patterns.

In addition, the inner surfaces of the light absorption layer defining the recesses may be connected to the top surface of the light absorption layer through a round portion. Thus, breakage between the contact pattern and the front electrode layer can be prevented.

### BRIEF DESCRIPTION OF THE DRAWINGS

Figs. 1 to 9 are cross-sectional views illustrating a method of fabricating a solar cell apparatus according to a first embodiment.
Fig. 2 is a plan view illustrating a mask for forming a back electrode layer.
Fig. 3 is a plan view illustrating a back electrode layer formed using the mask of Fig. 2.
Figs. 10 to 17 are cross-sectional views illustrating a method of fabricating a solar cell according to a second embodiment.
Fig. 13 is a plan view illustrating a first mask according to the second embodiment.
Fig. 17 is a plan view illustrating a second mask according to the second embodiment.

### MODE FOR CARRYING OUT THE INVENTION

In the description of embodiments, it will be understood that when a substrate, layer, film, or electrode is referred to as being 'on' or 'under' another substrate, layer, film, or electrode, the terminology of 'on' and 'under' includes both the meanings of 'directly' and 'indirectly'. Further, the reference about 'on' and 'under' each component will be made on the basis of drawings. In addition, the sizes of elements and the relative sizes between elements may be exaggerated for further understanding of the present disclosure.

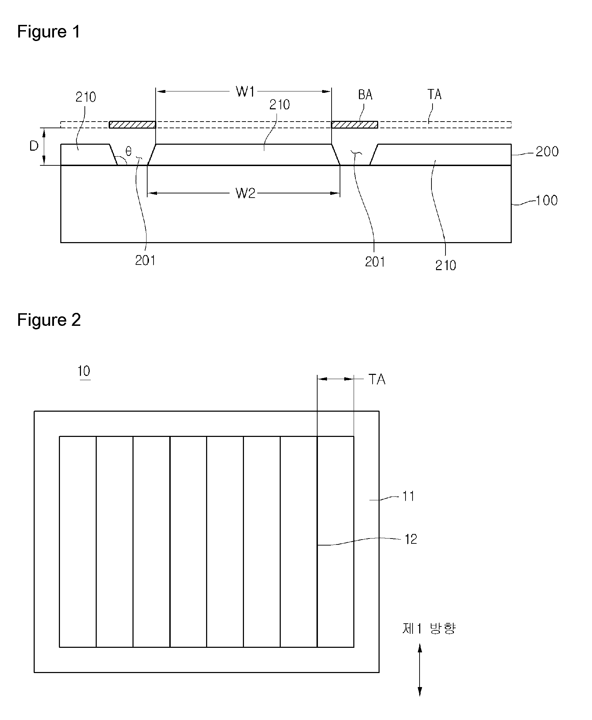

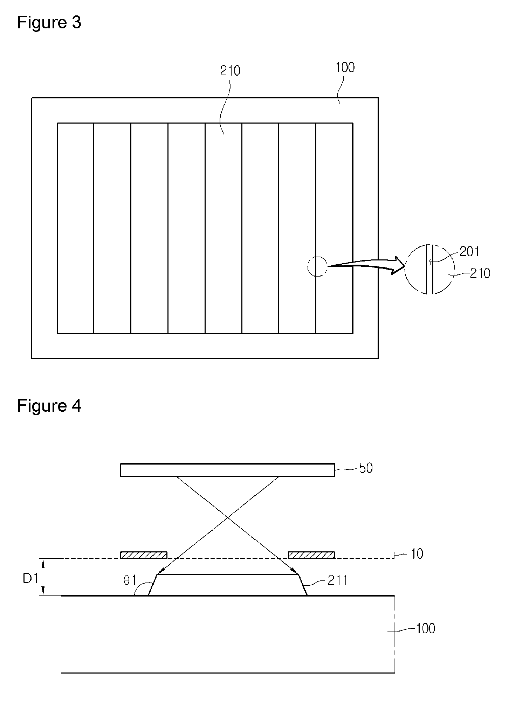

Figs. 1 and 4 to 9 are cross-sectional views illustrating a method of fabricating a solar cell apparatus according to a first embodiment. Fig. 2 is a plan view illustrating a mask for forming a back electrode layer. Fig. 3 is a plan view illustrating a back electrode layer formed using the mask of Fig. 2.

Referring to Figs. 1 and 3, a substrate 100 is prepared, and a back electrode layer 200 is formed on the substrate 100.

The substrate 100 is formed of glass, or may be formed of ceramic such as alumina, stainless steel, titanium, or polymer. Glass used to form the substrate 100 may be sodalime glass, and polymer used to form the substrate 100 may be polyimide. The substrate 100 may be rigid or flexible.

A mask 10 is placed on the substrate 100 to form the back electrode layer 200.

The mask 10 is used to selectively deposit a material on the substrate 100, thereby forming the back electrode layer 200. Referring to Fig. 2, the mask 10 may include a tetragonal frame 11 and a plurality of metal wires 12 fixed to the tetragonal frame 11. The metal wires 12 extend in a first direction, and are parallel to one another. Both ends of the metal wires 12 are fixed to the tetragonal frame 11, and the metal wires 12 are strained.

The mask 10 includes a plurality of transmitting areas TA and a plurality of blocking areas BA. The transmitting areas TA are disposed between the metal wires 12, and the blocking areas BA correspond to the metal wires 12.

That is, a material is deposited on the substrate 100 through the transmitting areas TA of the mask 10 to form the back electrode layer 200. The blocking areas BA of the mask 10 block the material used to form the back electrode layer 200.

For example, the material used to form the back electrode layer 200 may be a conductor such as a metal. For example, the back electrode layer 200 may be formed through a sputtering process using a molybdenum (Mo) target.

Mo has high electrical conductivity, an ohmic contact with a light absorption layer, and high temperature stability in Se atmosphere.

The mask 10 is open only in regions corresponding to the back electrode layer 200. That is, the mask 10 may cover only regions dividing the back electrode layer 200.

Thus, first through recesses 201 are formed in the back electrode layer 200 to correspond to the metal wires 12. The first through recesses 201 expose the top surface of the substrate 100. The first through recesses 201 extend in the first direction. The first through recesses 201 divide the back electrode layer 200 into back electrodes 210.

Inner surfaces of the back electrode layer 200 defining the first through recesses 201 are inclined from the top surface of the substrate 100. An upper width of the first through recesses 201 is greater than a bottom width of the first through recesses 201. The bottom width of the first through recesses 201 may range from about 50 µm to about 100 µm.

The back electrodes 210 have inclined side walls. For example, the back electrodes 210 may have a trapezoidal cross-section. That is, the back electrodes 210 may have an upper width W1 that is smaller than a lower width W2 contacting the substrate 100.

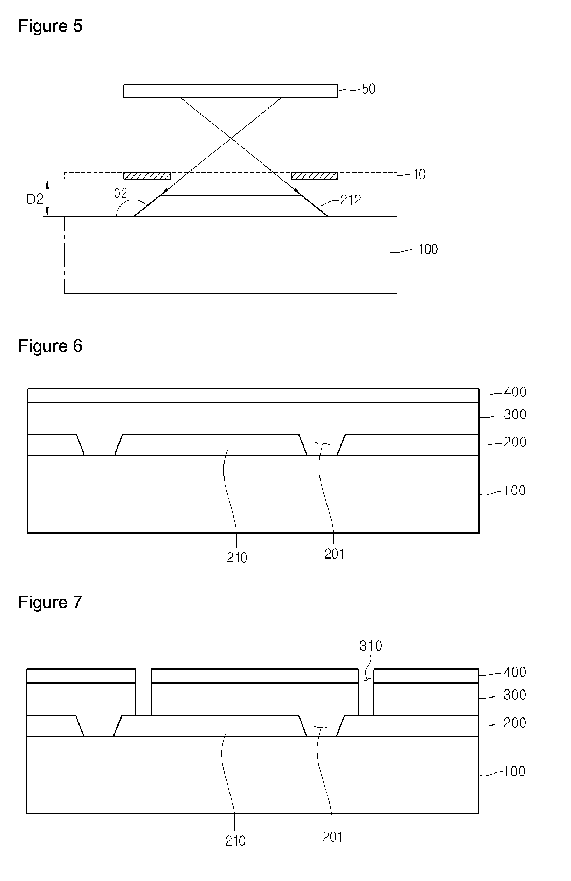

An inclination angle of the side walls of the back electrodes 210 may be controlled according to an installation height of the mask 10. A method of controlling the inclination angle of the side walls of the back electrodes 210 is illustrated in Figs. 4 and 5.

Referring to Fig. 4, the mask 10 is spaced apart from the substrate 100 by a first distance D1, and then, a deposition process is performed with a target 50. Referring to Fig. 5, the mask 10 is spaced apart from the substrate 100 by a second distance D2, and then, a deposition process is performed with the target 50.

Since the second distance D2 is greater than the first distance D1, a second angle θ2 formed using the second distance D2 is greater than a first angle θ1 formed using the first distance D1.

That is, due to shadow effect, the inclination angle of back electrodes 212 formed using the second distance D2 is greater than the inclination angle of back electrodes 211 formed using the first distance D1.

Thus, an inclination angle θ between the substrate 100 and the inner surfaces defining the first through recesses 201 can be controlled by controlling the distance between the mask 10 and the substrate 100. Accordingly, as a distance D between the mask 10 and the substrate 100 increases, the inclination angle θ increases.

The angle between the top surface of the substrate 100 and the inner surfaces defining the first through recesses 201, that is, the inclination angle θ may range from about 91 µm to about 170°. In more detail, the inclination angle θ is an angle between the top surface of the substrate 100 and a substantial extending direction of the inner surfaces defining the first through recesses 201, and may range from about 100 ° to about 120°.

As described above, the first through recesses 201 expose the top surface of the substrate 100, and separates the back electrodes 210 from one another. Thus, a non-vacuum type patterning process in which the back electrodes 210 are separated to form the back electrode layer 200 is unnecessary. Accordingly, a stand-by time for performing a non-vacuum type patterning process such as a laser scribing process for separating the back electrodes 210 is unnecessary.

In addition, since a light absorption layer forming process can be directly performed in a vacuum, a process time can be reduced. In addition, since a pattern is formed without using laser, burring of the back electrodes 210 can be prevented. That is, the back electrodes 210 are formed without forcibly removing a portion of the back electrode layer 200. Accordingly, partial burring of the back electrodes 210, and degradation of the back electrodes 210 due to a patterning process can be prevented. As a result, adhering characteristics between the back electrode layer 200 and the substrate 100 are improved.

The mask 10 may be formed of a metal and a material used to form the back electrode layer 200. For example, the metal wires 12 may be formed of molybdenum.

Although not shown, the back electrode layer 200 may be constituted by at least one layer. When the back electrode layer 200 is constituted by a plurality of layers, the layers may be formed of different materials.

The back electrode layer 200 may be provided in a stripe form as illustrated in Fig. 3, or in a matrix form, which correspond to the form of solar cells.

However, the form of the back electrode layer 200 is not limited thereto.

Referring to Fig. 6, a light absorption layer 300 and a buffer layer 400 are formed on the back electrode layer 200.

The light absorption layer 300 includes a Ib-IIIb-VIb based compound. In more detail, the light absorption layer 300 includes a copper-indium-gallium-selenide based (Cu(In, Ga)Se2; CIGS based) compound.

Alternatively, the light absorption layer 300 may include a copper-indium-selenide based (CuInSe2; CIS based) compound, or a copper-gallium-selenide based (CuGaSe2; CGS based) compound.

For example, a CIG based metal precursor film may be formed on the back electrode layer 200 with a copper target, an indium target, and a gallium target to form the light absorption layer 300.

Thereafter, the CIG based metal precursor film reacts with selenium (Se) through a selenization process to form a CIGS based light absorption layer as the light absorption layer 300.

During a process of forming the CIG based metal precursor film and the selenization process, alkali components from the substrate 100 are diffused through the back electrode layer 200 into the CIG based metal precursor film and the light absorption layer 300. The alkali components improve grain sizes and crystallinity of the light absorption layer 300.

Alternatively, the light absorption layer 300 may be formed from copper (Cu) indium (In) gallium (Ga), and selenide (Se) through co-evaporation.

The light absorption layer 300 receives and converts light into electrical energy. The light absorption layer 300 generates photoelectron-motive force through photoelectric effect.

A material used to form the light absorption layer 300 fills the first through recesses 201.

The buffer layer 400 may be constituted by at least one layer, which may be formed of one of cadmium sulfide (CdS), ITO, ZnO, i-ZnO, and a combination thereof on the substrate 100 with the light absorption layer 300 formed.

The buffer layer 400 is an n-type semiconductor layer, and the light absorption layer 300 is a p-type semiconductor layer. Accordingly, the light absorption layer 300 and the buffer layer 400 form a pn junction.

The buffer layer 400 is disposed between the light absorption layer 300 and a front electrode to be formed later.

That is, since the light absorption layer 300 is significantly different from the front electrode in lattice constant and energy band gap, the buffer layer 400, which has a band gap between those of the light absorption layer 300 and the front electrode, may be disposed therebetween to improve bonding efficiency.

Although a single layer as the buffer layer 400 is formed on the light absorption layer 300, the buffer layer 400 may be provided in plurality.

Then, referring to Fig. 7, second through recesses 310, which pass through the light absorption layer 300 and the buffer layer 400, are formed.

The second through recesses 310 may be formed using a mechanical method to partially expose the back electrode layer 200.

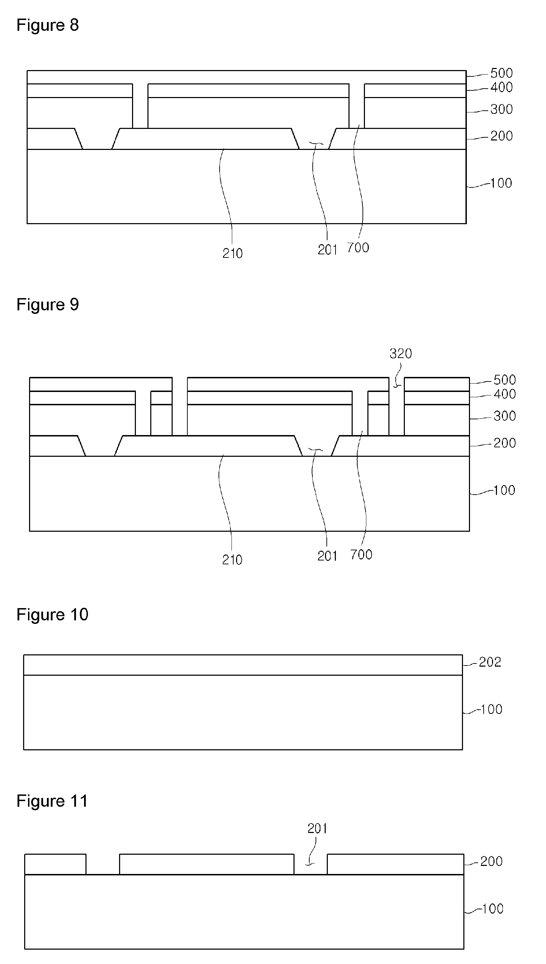

Then, referring to Fig. 8, a transparent conductive material is formed on the buffer layer 400 to form a front electrode layer 500 and a plurality of connecting lines 700.

At this point, the transparent conductive material fills the contact patterns 310, thereby forming the connecting lines 700.

The back electrode layer 200 is electrically connected to the front electrode layer 500 by the connecting lines 700.

The front electrode layer 500 is formed of an aluminum-doped zinc oxide on the substrate 100 through a sputtering process.

Since the front electrode layer 500, which is a window layer forming a pn junction with the light absorption layer 300, functions as a transparent electrode on the front surface of a solar cell, the front electrode layer 500 is formed of zinc oxide (ZnO) having high light transmissivity and high electrical conductivity.

At this point, the zinc oxide may be doped with aluminum to form an electrode having low resistance.

A zinc oxide thin film as the front electrode layer 500 may be deposited using a radio frequency (RF) sputtering method with a ZnO target, using a reactive sputtering method with a Zn target, or using a metal organic chemical vapor deposition method.

Alternatively, a double structure that an indium tin oxide (ITO) thin film having excellent electro-optical characteristics is deposited on a zinc oxide thin film may be used.

Then, referring to Fig. 9, isolation patterns 320, which pass through the light absorption layer 300, the buffer layer 400, and the front electrode layer 500, are formed.

The isolation patterns 320 may be formed using a mechanical method to partially expose the back electrode layer 200.

The isolation patterns 320 may divide the buffer layer 400 and the front electrode layer 500, and isolate the cells from one another.

The front electrode layer 500, the buffer layer 400, and the light absorption layer 300 may be disposed in a stripe or matrix form by means of the isolation patterns 320.

The form of the isolation patterns 320 is not limited thereto.

The isolation patterns 320 define cells C1 and C2, which include the back electrode layer 200, the light absorption layer 300, the buffer layer 400, and the front electrode layer 500.

The cells C1 and C2 may be connected to each other through the connecting lines 700. That is, a portion of the back electrode layer 200 corresponding to a first cell is electrically connected to a portion of the front electrode layer 500 corresponding to a second cell adjacent to the first cell by the connecting line 700.

As shown in Fig. 9, the solar cell apparatus according to the current embodiment includes the substrate 100, the back electrode layer 200, the light absorption layer 300, and the front electrode layer 500.

The back electrode layer 210 may be spaced apart from one another on the substrate 100. The light absorption layer 300 may partially include the contact patterns 310 on the back electrode layer 200 to connect electrodes, and the isolation patterns 320 for forming unit cells.

The front electrode layer 500 is disposed on the light absorption layer 300, and is divided by the isolation patterns 320.

The front electrode layer 500 fills the contact patterns 310 to electrically connect to the back electrode layer 200, and the side walls of the back electrodes 210 may be inclined.

As described above, since all processes for fabricating the solar cell are performed in a vacuum without a stand-by process for patterning the back electrode layer 200, the process time can be reduced.

In addition, the back electrode layer 200 is formed using the mask 10, to thereby prevent burring due to a patterning process using laser. In addition, since a patterning process can be more precisely performed, a non-active area NAA can be decreased, thereby improving optical efficiency of the solar cell apparatus.

That is, according to the current embodiment, the back electrodes 210 are separated using the mask 10 in a vacuum. Thus, a non-vacuum type process for patterning the back electrode layer 200 is unnecessary.

Accordingly, the process time can be reduced, and the back electrode layer 200 can be protected from a mechanical or thermal shock.

Figs. 10 to 12, and 14 to 16 are cross-sectional views illustrating a method of fabricating a solar cell according to a second embodiment. The current embodiment may refer to the previous embodiment. That is, the previous embodiment may be substantially coupled to the current embodiment except for modified parts.

First, referring to Fig. 10, a preliminary back electrode layer 202 is formed on the substrate 100.

A substrate 100 is formed of glass, or may be formed of ceramic such as alumina, stainless steel, titanium, or polymer. Glass used to form the substrate 100 may be sodalime glass, and polymer used to form the substrate 100 may be polyimide. The substrate 100 may be rigid or flexible.

The preliminary back electrode layer 202 is formed of a conductor such as a metal. For example, the preliminary back electrode layer 202 may be formed through a sputtering process using a molybdenum (Mo) target. Mo has high electrical conductivity, an ohmic contact with a light absorption layer, and high temperature stability in Se atmosphere. Although not shown, the preliminary back electrode layer 202 may be constituted by at least one layer. When the preliminary back electrode layer 202 is constituted by a plurality of layers, the layers may be formed of different materials.

Then, referring to Fig. 11, the preliminary back electrode layer 202 is patterned to form a back electrode layer 200. The back electrode layer 200 may expose the substrate 100 through first through recesses 201.

The back electrode layer 200 may be provided in a stripe form or a matrix form, which corresponds to the form of solar cells. However, the form of the back electrode layer 200 is not limited thereto.

The back electrode layer 200 may be formed by depositing molybdenum through a mask 10, like in the previous embodiment. That is, the back electrode layer 200 may be formed through a mask patterning process, without using a laser patterning process.

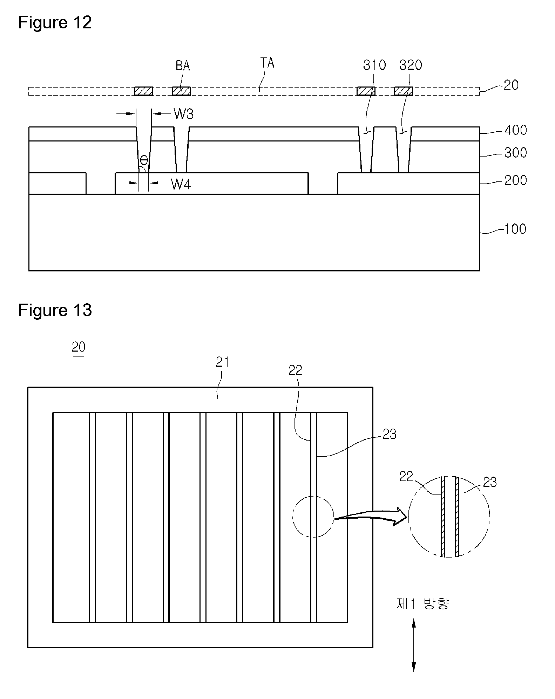

Thereafter, referring to Fig. 12, a light absorption layer 300 and a buffer layer 400 are formed on the back electrode layer 200.

To this end, a first mask 20 is disposed on the back electrode layer 200. The first mask 20 is used to selectively deposit a material on the back electrode layer 200, thereby forming the light absorption layer 300. The first mask 20 is used to selectively deposit a material on the back electrode layer 200, thereby forming the buffer layer 400.

Referring to Fig. 13, the first mask 20 may include a first tetragonal frame 21, a plurality of first metal wires 22 fixed to the first tetragonal frame 21, and a plurality of second metal wires 23 fixed to the first tetragonal frame 21. The first and second metal wires 22 and 23 extend in a first direction, and are parallel to one another. Both ends of the first and second metal wires 22 and 23 are fixed to the first tetragonal frame 21, and the first and second metal wires 22 and 23 are strained.

A plurality of the first metal wires 22 and a plurality of the second metal wires 23 are disposed in pairs. That is, the first metal wires 22 are adjacent to the second metal wires 23, respectively.

The first mask 20 includes a plurality of transmitting areas TA and a plurality of blocking areas BA. The transmitting areas TA are disposed between the first and second metal wires 22 and 23, and the blocking areas BA correspond to the first and second metal wires 22 and 23.

That is, a material is deposited on the back electrode layer 200 through the transmitting areas TA of the first mask 20 to form the light absorption layer 300. In addition, a material is deposited on the light absorption layer 300 through the transmitting areas TA of the first mask 20 to form the buffer layer 400. In addition, the blocking areas BA of the first mask 20 block the materials used to form the light absorption layer 300 and the buffer layer 400.

The light absorption layer 300 includes a Ib-IIIb-VIb based compound. In more detail, the light absorption layer 300 includes a copper-indium-gallium-selenide based (Cu(In, Ga)Se2; CIGS based) compound.

Alternatively, the light absorption layer 300 may include a copper-indium-selenide based (CuInSe2; CIS based) compound, or a copper-gallium-selenide based (CuGaSe2; CGS based) compound.

For example, a CIG based metal precursor film may be formed on the back electrode layer 200 with a copper target, an indium target, and a gallium target to form the light absorption layer 300.

Thereafter, the CIG based metal precursor film reacts with selenium (Se) through a selenization process to form a CIGS based light absorption layer as the light absorption layer 300.

During a process of forming the CIG based metal precursor film and the selenization process, alkali components from the substrate 100 are diffused through the back electrode layer 200 into the CIG based metal precursor film and the light absorption layer 300. The alkali components improve grain sizes and crystallinity of the light absorption layer 300.

Alternatively, the light absorption layer 300 may be formed from copper (Cu) indium (In) gallium (Ga), and selenide (Se) through co-evaporation.

The light absorption layer 300 receives and converts light into electrical energy. The light absorption layer 300 generates photoelectron-motive force through photoelectric effect.

The buffer layer 400 may be constituted by at least one layer, which may be formed of one of cadmium sulfide (CdS), ITO, ZnO, i-ZnO, and a combination thereof on the substrate 100 with the light absorption layer 300 formed.

The buffer layer 400 is an n-type semiconductor layer, and the light absorption layer 300 is a p-type semiconductor layer. Accordingly, the light absorption layer 300 and the buffer layer 400 form a pn junction.

The buffer layer 400 is disposed between the light absorption layer 300 and a front electrode layer 500 to be formed later. That is, since the light absorption layer 300 is significantly different from the front electrode layer 500 in lattice constant and energy band gap, the buffer layer 400, which has a band gap between those of the light absorption layer 300 and the front electrode layer 500, may be disposed therebetween to improve bonding efficiency.

Although a single layer as the buffer layer 400 is formed on the light absorption layer 300, the buffer layer 400 may be provided in plurality.

At this point, the light absorption layer 300 and the buffer layer 400 are formed using the first mask 20. Accordingly, second through recesses 310 and third through recesses 320 are formed in the light absorption layer 300 and the buffer layer 400. The second through recesses 310 and the third through recesses 320 pass through the light absorption layer 300 and the buffer layer 400.

That is, a deposition process such as sputtering through the first mask 20 is performed on the substrate 100 with the back electrode layer 200 formed. Accordingly, the second through recesses 310 are formed in areas corresponding to the first metal wires 22. In addition, the third through recesses 320 are formed in areas corresponding to the second metal wires 23.

The second and third through recesses 310 and 320 expose the back electrode layer 200. Inner surfaces of the light absorption layer 300 and the buffer layer 400, which define the second and third through recesses 310 and 320, are inclined. Accordingly, an upper width W3 of the second through recesses 310 may be greater than a lower width W4 thereof. Also, an upper width of the third through recesses 320 may be greater than a lower width thereof.

In a same manner as that of the first embodiment, inclination angles of the inner surfaces defining the second and third through recesses 310 and 320 may be controlled through shadow effect according to an installation height of the first mask 20.

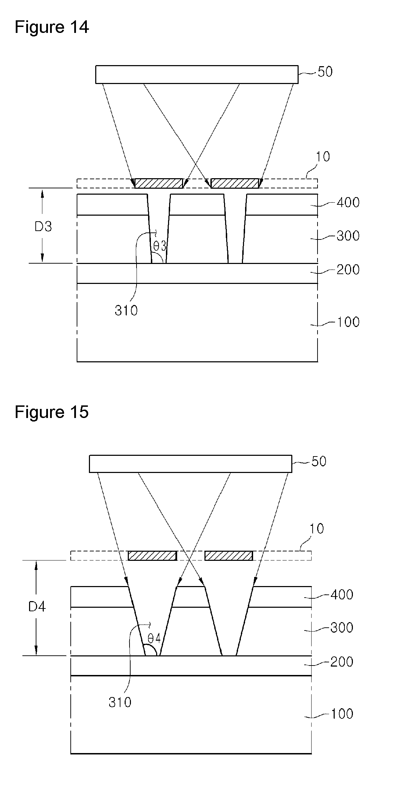

A method of controlling the inclination angle of the inner surfaces defining the second through recesses 310 is illustrated in Figs. 14 and 15.

Referring to Fig. 14, the first mask 20 is spaced apart from the back electrode layer 200 by a third distance D3, and then, a deposition process is performed a the target 50. Referring to Fig. 15, the first mask 10 is spaced apart from the back electrode layer 200 by a fourth distance D4, and then, a deposition process is performed with the target 50.

Since the fourth distance D4 is greater than the third distance D3, a fourth angle θ4 formed using the fourth distance D4 is greater than a third angle θ3 formed using the third distance D3.

That is, due to shadow effect, the inclination angle of the inner surfaces defining the second through recesses 310 formed using the fourth distance D4 is greater than that of the inner surfaces defining the second through recesses 310 formed using the third distance D3.

Thus, a contact angle θ between the back electrode layer 200 and connecting lines 700 formed in the second through recesses 310 can be controlled by controlling the distance between the first mask 20 and the back electrode layer 200. Accordingly, as a distance D between the first mask 20 and the back electrode layer 200 increases, the inclination angle θ may increase.

The third angle θ3 and the fourth angle θ4 are angles between the top surface of the back electrode layer 200 and the inner surface defining the second through recesses 310. In more detail, the third angle θ3 and the fourth angle θ4 are angles between the top surface of the substrate 100 and the inner surface defining the second through recesses 320. That is, the top surface of the back electrode layer 200 is substantially parallel to the top surface of the substrate 100.

A first inclination angle (also denoted by θ) between the top surface of the back electrode layer 200 and the inner surface defining the second through recesses 320 may range from about 91° to about 170°. In more detail, the first inclination angle θ may range from about 91° to about 120°.

Also, a second inclination angle between the top surface of the back electrode layer 200 and the inner surface defining the third through recesses 320 may range from about 91° to about 170°. In more detail, the second inclination angle may range from about 91° to about 120°.

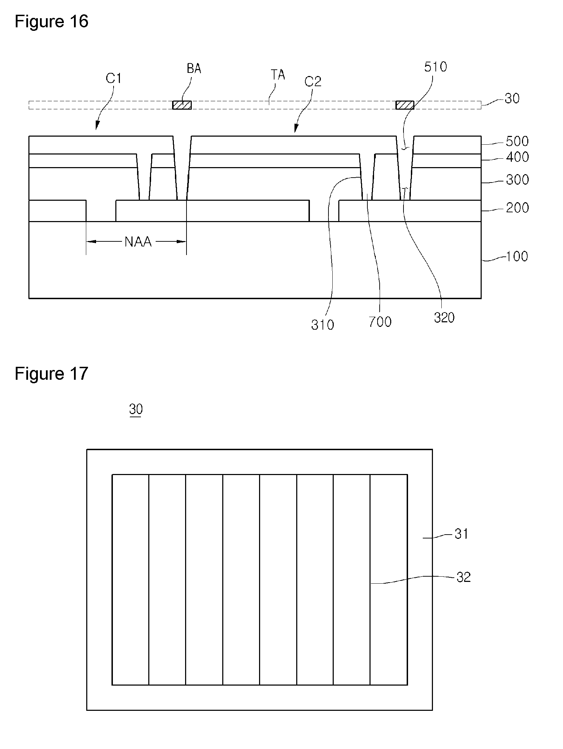

Thereafter, referring to Fig. 16, a transparent conductive material is formed on the buffer layer 400 to form the front electrode layer 500 and the connecting lines 700.

The front electrode layer 500 may be formed using a second mask 30. The second mask 30 is used to selectively deposit a material on the buffer layer 400, thereby forming the front electrode layer 500. In more detail, a material is deposited through the second mask 30 on the buffer layer 400, so that the front electrode layer 500 is formed out of areas corresponding to the third through recesses 320.

That is, the second mask 30 may be placed on the substrate 100 provided with the buffer layer 400, and then, the front electrode layer 500 may be formed through a deposition process such as sputtering.

Referring to Fig. 17, the second mask 30 may include a second tetragonal frame 31, and a plurality of third metal wires 32 fixed to the second tetragonal frame 31. The third metal wires 32 extend in the first direction, and are parallel to one another. Both ends of the third metal wires 32 are fixed to the second tetragonal frame 31, and the third metal wires 32 are strained.

The second mask 30 includes a plurality of transmitting areas TA and a plurality of blocking areas BA. The transmitting areas TA are disposed between the third metal wires 32, and the blocking areas BA correspond to the third metal wires 32.

That is, a material is deposited on the buffer layer 400 through the transmitting areas TA of the second mask 30 to form the front electrode layer 500. The blocking areas BA of the second mask 30 block the material used to form the front electrode layer 500.

The third metal wires 32 correspond to the third through recesses 320, respectively. That is, the second mask 30 is disposed on the buffer layer 400 such that the third metal wires 32 correspond to the third through recesses 320.

Thus, fourth through recesses 510, which correspond to the third through recesses 320, are formed in the front electrode layer 500. The third through recesses 320 may be connected to the fourth through recesses 510, and be integrated thereto.

Alternatively, although not shown, the third through recesses 320 may be slightly misaligned with the fourth through recesses 510.

Inner surfaces of the front electrode layer 500 defining the fourth through recesses 510 may be inclined from the top surface of the substrate 100. That is, the inner surfaces defining the fourth through recesses 510 may be inclined from the top surface of the light absorption layer 300. In addition, the inner surfaces defining the fourth through recesses 510 may be inclined from the top surface of the buffer layer 400.

The fourth through recesses 510 may have a reverse trapezoidal cross-section. That is, an upper width of the fourth through recesses 510 may be greater than a lower width thereof. As described above, a third inclination angle of the fourth through recesses 510 may be controlled by controlling an installation height of the second mask 30.

The third inclination angle, which is an angle between the top surface of the substrate 100 and the inner surface defining the fourth through recesses 510, may range from about 91° to about 170°. In more detail, the third inclination angle may range from about 91° to about 120°. The top surface of the substrate 100 may be substantially parallel to the top surface of the buffer layer 400.

For example, the front electrode layer 500 may be formed of a transparent conductive material. For example, the transparent conductive material may be an aluminum doped zinc oxide (Al doped ZnO; AZO) or indium tin oxide (ITO).

The transparent conductive material is deposited on the buffer layer 400 through the second mask 30. Accordingly, the transparent conductive material is deposited within the second through recesses 310 to form the connecting lines 700 therein. The back electrode layer 200 is electrically connected to the front electrode layer 500 by the connecting lines 700.

Since the front electrode layer 500, which is a window layer forming a pn junction with the light absorption layer 300, functions as a transparent electrode on the front surface of a solar cell, the front electrode layer 500 may be formed of zinc oxide (ZnO) having high light transmissivity and high electrical conductivity. At this point, the zinc oxide may be doped with aluminum to form an electrode having low resistance.

A zinc oxide thin film as the front electrode layer 500 may be deposited using a radio frequency (RF) sputtering method with a ZnO target, using a reactive sputtering method with a Zn target, or using a metal organic chemical vapor deposition method.

Alternatively, a double structure that an indium tin oxide (ITO) thin film having excellent electro-optical characteristics is deposited on a zinc oxide thin film may be used.

The third through recesses 320 are connected to the fourth through recesses 510 to form isolation patterns. Accordingly, the isolation patterns may divide the buffer layer 400 and the front electrode layer 500, and isolate the cells from one another.

The buffer layer 400 and the light absorption layer 300 may be disposed in a stripe or matrix form by means of the isolation patterns. The form of the isolation patterns is not limited thereto.

The isolation patterns define cells, which include the back electrode layer 200, the light absorption layer 300, the buffer layer 400, and the front electrode layer 500.

The cells may be connected to each other through the connecting lines 700. That is, a portion of the back electrode layer 200 corresponding to a first cell is electrically connected to a portion of the front electrode layer 500 corresponding to a second cell adjacent to the first cell by the connecting line 700.

A solar cell apparatus according to the current embodiment includes the substrate 100, the back electrode layer 200, the light absorption layer 300, and the front electrode layer 500.

Back electrodes of the back electrode layer 200 may be spaced apart from one another on the substrate 100. The light absorption layer 300 may partially include the contact patterns 310 on the back electrode layer 200 to connect electrodes, and the isolation patterns for forming unit cells.

The front electrode layer 500 is disposed on the light absorption layer 300, and is divided by the isolation patterns.

The front electrode layer 500 fills the contact patterns 310 to electrically connect to the back electrode layer 200.

The second and third through recesses 310 and 320 may have inclined side walls, and an upper width of the second and third through recesses 310 and 320 may be greater than a lower width thereof.

According to the current embodiment, since all processes for fabricating the solar cell are performed in a vacuum without a stand-by process for patterning, the process time can be reduced.

When the light absorption layer 300, the buffer layer 400, and the front electrode layer 500 are formed, the first and second masks 20 and 30 are used. At this point, the second through recesses 310, the third through recesses 320, and the fourth through recesses 510 may be formed through a vacuum deposition process. Accordingly, ripping due to mechanical patterning can be prevented.

Patterning according to the current embodiment is more precise than mechanical patterning. Accordingly, the non-active area NAA can be decreased, and optical efficiency of the solar cell apparatus can be improved.

In addition, since the light absorption layer 300 and the buffer layer 400 are formed using the first mask 20, an additional patterning process and a stand-by process for patterning are unnecessary.

Thus, since a front electrode forming process, which is a subsequent process requiring a vacuum state, can be directly performed, the process time can be reduced. In addition, since a pattern is formed without using a mechanical method, ripping of the light absorption layer 300 and the buffer layer 400 can be prevented.

In addition, inner uniformity of the second through recesses 310 is better than in a patterning process using a mechanical method. In addition, the top surface of the buffer layer 400 is not perpendicular to the inner surfaces defining the second through recesses 310, and is gently connected thereto. For example, the top surface of the buffer layer 400 may be connected through a round portion to the inner surfaces defining the second through recesses 310.

Thus, the transparent conductive material can be efficiently deposited on the inner surfaces defining the second through recesses 310. Accordingly, coverage of the connecting lines 700 is improved, to thereby reduce sheet resistance thereof. In addition, since the transparent conductive material can be efficiently deposited on the inner surfaces, breakage of the connecting lines 700 can be prevented.

In addition, since the light absorption layer 300 and the buffer layer 400 are formed by performing a patterning process and a deposition process at the same time by means of the first mask 20, the patterning process is more precise, thereby decreasing the non-active area NAA, and improving the optical efficiency of the solar cell.

In addition, since the front electrode layer 500 is formed using the second mask 30, an additional patterning process and a stand-by process for patterning are unnecessary.

Furthermore, since an additional patterning process is unnecessary, the process time can be reduced. In addition, since a pattern is formed without using a mechanical method, ripping of the front electrode layer 500 can be prevented.

The first mask 20 and the second mask 30 may be formed of a material used to form the back electrode layer 200. For example, the first and second masks 20 and 30 may be formed of molybdenum.

Although the first embodiment is separated from the second embodiment herein, they are coupled to each other within the spirit and scope of the present disclosure.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### INDUSTRIAL APPLICABILITY

The solar cell apparatus according to the embodiment is used in the field of photovoltaic power generation.

## Claims

1. A solar cell apparatus comprising:
a substrate;
a back electrode layer on the substrate;
a light absorption layer on the back electrode layer; and
a front electrode layer on the light absorption layer,
wherein the back electrode layer is provided with recesses, and
inner surfaces of the back electrode layer defining the recesses are inclined from a top surface of the substrate.

2. The solar cell apparatus according to claim 1, wherein the back electrode layer comprises back electrodes separated by the recesses, and
an upper width of the back electrodes is smaller than a lower width of the back electrodes.

3. The solar cell apparatus according to claim 1, wherein an angle between the inner surface defining the recesses and the top surface of the substrate ranges from about 91° to about 120°.

4. The solar cell apparatus according to claim 1, wherein a bottom width of the recesses ranges from about 50 µm to about 100 µm.

5. A solar cell apparatus comprising:
a substrate;
a back electrode layer on the substrate;
a light absorption layer on the back electrode layer; and
a front electrode layer on the light absorption layer,
wherein the light absorption layer is provided with first recesses, and
inner surfaces of the light absorption layer defining the first recesses are inclined from a top surface of the substrate.

6. The solar cell apparatus according to claim 5, wherein the front electrode layer is provided with second recesses, and
inner surfaces of the front electrode layer defining the second recesses are inclined from the top surface of the substrate.

7. The solar cell apparatus according to claim 6, wherein the second recesses pass through the front electrode layer and the light absorption layer.

8. The solar cell apparatus according to claim 6, wherein the back electrode layer is provided with third recesses, and
the third recesses are inclined from the top surface of the substrate.

9. The solar cell apparatus according to claim 6, wherein an angle between the inner surface defining the second recesses and the top surface of the substrate ranges from about 91° to about 120°.

10. The solar cell apparatus according to claim 5, comprising contact patterns that are disposed in the first recesses, respectively,
wherein side surfaces of the contact patterns are inclined from the top surface of the substrate.

11. The solar cell apparatus according to claim 9, wherein the side surfaces of the contact patterns directly contact and the inner surfaces defining the third recesses.

12. The solar cell apparatus according to claim 5, wherein an angle between the inner surface defining the first recesses and the top surface of the substrate ranges from about 91° to about 120°.

13. The solar cell apparatus according to claim 5, comprising a buffer layer between the light absorption layer and the front electrode layer,
wherein the first recesses pass through the buffer layer and the light absorption layer.

14. The solar cell apparatus according to claim 13, wherein contact portions between a top surface of the buffer layer and the first recesses are round.

15. A method of fabricating a solar cell apparatus, comprising:
forming a back electrode layer on a substrate;
forming a light absorption layer on the back electrode layer; and
forming a front electrode layer on the light absorption layer,
wherein, in the forming of the back electrode layer, the light absorption layer, or the front electrode layer, a mask is disposed on the substrate, and then, a raw material used to form the back electrode layer, the light absorption layer, or the front electrode layer is deposited.

16. The method according to claim 15, wherein the back electrode layer, the light absorption layer, and the front electrode layer are formed using different masks.

17. The method according to claim 15, wherein the mask has a width ranging from to.

18. The method according to claim 15, comprising forming a buffer layer between the light absorption layer and the front electrode layer,
wherein the forming of the light absorption layer and the forming of the buffer layer comprise:
disposing the mask on the back electrode layer;
using a first mask as a deposition mask to form the light absorption layer; and
using the first mask as a deposition mask to form the buffer layer on the light absorption layer,
wherein the light absorption layer is provided with first recesses, and the buffer layer is provided with second recesses that are adjacent to the first recesses, respectively.

19. The method according to claim 18, wherein inner surfaces of the light absorption layer defining the first recesses are inclined from a top surface of the substrate.

20. The method according to claim 18, wherein the forming of the front electrode layer comprises:
disposing a second mask on the buffer layer; and
using the second mask as a deposition mask to form the front electrode layer,
wherein the second mask correspond to the second recesses.
